# EUROPÄISCHE PATENTSCHRIFT

(11) **EP 0 489 759 B1**
(45) Veröffentlichungstag und Bekanntmachung des Hinweises auf die Patenterteilung: **02.11.1994**
(21) Anmeldenummer: 90912088.3
(22) Anmeldetag: 11.08.1990
(51) Int. Cl.: H05K 3/42

(54) **VERFAHREN ZUR HERSTELLUNG EINER DURCHKONTAKTIERTEN LEITERPLATTE**
PROCESS FOR PRODUCING A PLATED-THROUGH PRINTED CIRCUIT BOARD
PROCEDE POUR LA FABRICATION D'UNE CARTE DE CIRCUITS IMPRIMES A TROUS METALLISES

(30) Priorität: 31.08.1989 DE 3928832
(43) Veröffentlichungstag der Anmeldung: 17.06.1992
(73) Patentinhaber: Blasberg-Oberflächentechnik GmbH, D-42699 Solingen (DE)
(72) Erfinder: HUPE, Jürgen, D-4018 Langenfeld (DE); KRONENBERG, Walter, D-5000 Köln 80 (DE)
(74) Vertreter: Werner, Hans-Karsten, Dr.Dipl.-Chem.
(86) Internationale Anmeldenummer: EP9001326
(87) Internationale Veröffentlichungsnummer: WO9103920

(56) Entgegenhaltungen:
- EP-A- 206 133
- EP-A- 248 683
- WO-A-89/08375
- DE-B- 1 299 740
- DE-C- 3 806 884
- GB-A- 2 123 036
- US-A- 4 604 427
- IBM TECHNICAL DISCLOSURE BULLETIN, vol. 22, No. 1, June 1979, NEW YORK, US, page 393, ENGLER: "Simple metallization procedure for insulating materials"
- CHEMISCHE INDUSTRIE, vol. 8, No. 6, 1987; pages 59-64; NAARMANN: "Elektrisch leitfähige Polymere: Anwendungs-Spektrum noch nicht ausgereizt"
- PATENT ABSTRACTS OF JAPAN, vol. 12, No. 373 (C-534)(3220) 6 October 1988 & JP-A-63 125696

## Beschreibung

Gegenstand der vorliegenden Erfindung ist ein Verfahren zur Herstellung von durchkontaktierten ein- oder mehrlagigen Leiterplatten auf Basis eines gegebenenfalls beidseitig mit mindestens einer das elektrisch leitende Leitungsbild temporär freilegenden Photoresistschicht versehenen polymeren Trägermaterials oder Keramik durch galvanisches oder außenstromloses Auftragen einer Metallschicht auch auf den Oberflächen, die nicht mit einer leitenden Metallschicht überzogen sind, sowie die Verwendung einer wässrigen Lösung in einem solchen Verfahren.

Durchkontaktierte Leiterplatten werden bisher im wesentlichen durch chemische Metallabscheidung auf katalytisch aktivierten Oberflächen eines Trägermaterials hergestellt. Auch mehrlagige Leiterplatten (Multilayer) werden auf diese Weise produziert. Die außenstromlos niedergeschlagenen Metallschichten werden danach gegebenenfalls durch galvanische Metallabscheidung verstärkt. Diese Technologie erlaubt die Fertigung qualitativ hochwertiger Leiterplatten. Die katalytische Aktivierung der Oberfläche erfolgt im allgemeinen mittels edelmetallhaltiger, kolloidaler, ionogener oder nicht-ionogener Katalysatoren, insbesondere auf Basis von Palladium und Zinn. Es können aber auch nicht-edelmetallhaltige Systeme, zum Beispiel auf Basis von Kupfer, verwendet werden. In besonderen Fällen ist auch die Verwendung physikalisch aufgebrachter, zum Beispiel aufgedampfter, katalytisch wirkender Schichten bekannt.

Die Methoden sind in der einschlägigen Literatur, zum Beispiel Hermann, Handbuch der Leiterplattentechnik, Eugen G. Leuze Verlag, Saulgau beschrieben. Bei der in der Praxis angewandten naßchemischen Katalyse mittels edelmetallhaltiger oder nicht-edelmetallhaltiger Systeme ist im allgemeinen folgender Ablauf gegeben:
1. Reinigung/Konditionierung
2. Spülen
3. Aktivieren/Anätzen
4. Spülen
5. Vortauchlösung
6. Aufbringen des Katalysators
7. Spülen
8. Zugabe eines Beschleunigers/Reduktors
9. Erneutes Spülen
10. Außenstromlose Metallisierung
11. Spülen
12. Trocknen

Die Qualität der Bekeimung (Katalyse) und damit die Qualität des Endproduktes ist sehr stark von den Vorbehandlungsmethoden abhängig, die der Katalyse vorangehen. Dies gilt besonders für die Konditionierung, bei der einerseits die Oberflächen gereinigt werden, andererseits die Bohrlochwandungen für die folgende Katalyse vorbereitet werden. Die Vorbereitung erfolgt mittels spezieller Tenside, welche die gesamte Oberfläche belegen und die ausgeprägte Eigenschaft haben, die Katalysatorkeime zu adsorbieren. Der Anwendung des Katalysators ist eine dem System entsprechende Behandlung nachgeschaltet, die entweder störende Nebenprodukte der Katalysebehandlung entfernt oder aber die im Katalysator aufgebrachten Keime in ihre katalytisch wirksame Form überführt. Anschließend erfolgt die außenstromlose Metallisierung. Im allgemeinen wird Kupfer zur Abscheidung gebracht. Schon geringfügige Abweichungen von den vorgeschriebenen Prozeßparametern in einem der Verfahrensschritte führen üblicherweise zu einer fehlerhaften Metallisierung, so daß das Endprodukt in vielen Fällen unbrauchbar ist.

Ein wesentlicher Nachteil dieser Katalysatorsysteme ist demgemäß die Abhängigkeit der Bekeimungsdichte von der Vorbehandlung, der Teilchengröße und dem Nachbehandlungsschritt. Je höher die Bekeimungsdichte ist, um so besser ist die anfängliche Abscheidungsgeschwindigkeit bzw. die Dichte der beginnenden außenstromlosen Verkupferung, was gleichbedeutend mit hoher Durchkontaktierungsqualität ist. Es treten jedoch sehr leicht Fehlstellen, im Fachjargon sogenannte "voids" auf, welche die Durchkontaktierungsqualität stark mindern bzw. die Leiterplatten unbrauchbar machen. Aber selbst unter optimalen Bedingungen kann eine vollständig dicht mit Keimen belegte Oberfläche nicht erzielt werden. Darüber hinaus sind die bestehenden Katalysatorsysteme anfällig gegenüber eingeschleppten Fremdionen. Dadurch werden sowohl die Reproduzierbarkeit ihrer Arbeitsweise als auch ihre Stabilität stark beeinträchtigt. Ein weiterer Nachteil edelmetallhaltiger Katalysatorsysteme ist der hohe Preis der verwendeten Metalle.

Die Technologie gemäß dem Stand der Technik unter Verwendung einer außenstromlosen Metallisierung, die danach gegebenenfalls durch galvanische Metallabscheidung verstärkt wird, weist trotz ihrer weiten Verbreitung einige Nachteile auf, die bislang jedoch in Ermangelung von praktikablen Alternativen in Kauf genommen werden mußten. Vor allem die rein chemische Metallabscheidung aus reduktiv arbeitenden Elektrolyten ist sehr aufwendig und setzt eine genaue Analytik und Führung des Elektrolyten voraus. Diese Elektrolyte enthalten auch mit Abstand die teuersten Chemikalien. Dennoch sind derartig abgeschiedene Schichten physikalisch und mechanisch von geringerer Qualität als galvanisch abgeschiedene Metallschichten. Ein weiterer Nachteil der bisher angewendeten Technologie ist die Unsicherheit bei der Stabilisierung der Systeme und damit auch die Ungewißheit, ob die Abscheidungsgeschwindigkeit und Schichtdicke in den Bohrlochwandungen ausreichend reproduzierbar sind. Die Elektrolyte neigen aufgrund ihrer geringen Stabilität zur Selbstzersetzung. Die genannten Elektrolyte enthalten darüber hinaus als Reduktionsmittel in der Regel Formaldehyd, das unter Arbeitsschutzaspekten zu vermeiden ist. Weiterhin enthalten die reduktiv arbeitenden Elektrolyte größere Mengen von Komplexbildnern, die biologisch schwer abbaubar sind und deshalb eine erhebliche Belastung der Abwässer darstellen.

Schon seit langem ist versucht worden, auf die chemische Metallisierung zu verzichten und statt dessen eine direkte galvanische Metallabscheidung durchzuführen. Ein derartiges Verfahren ist beispielsweise in der US-PS 3,099,608 beschrieben worden sowie in der DE-OS 33 04 004. Die dort beschriebenen Verfahren haben jedoch keinen Eingang in die Praxis gefunden. Nur mit frisch zubereiteten galvanisch arbeitenden Elektrolyten können einigermaßen brauchbare Ergebnisse erzielt werden. Schon sehr rasch nach ihrer Inbetriebnahme sinkt die Qualität der erhaltenen Metallabscheidung so stark ab, daß nur noch unbrauchbare Ergebnisse erzielt werden. Außerdem sind recht lange Zeiten für die Metallabscheidung notwendig. Bei Anwendung des in der US-PS 3,099,608 beschriebenen Verfahrens werden mindestens 20 Minuten für die Metallabscheidung benötigt. Des weiteren treten auch sehr rasch in zunehmendem Maße Fehlstellen bei der Metallisierung auf. Dadurch entstehen auf der Lochwandung Metallschichten, die ungenügend haften.

In der nicht vorpublizierten DE-OS 38 06 884 der Anmelderin wird ein Verfahren zur Herstellung durchkontaktierter Leiterplatten vorgeschlagen, das eine sichere, haftfeste und geschlossene Aktivierung des verwendeten Basismaterials erlaubt, die Zahl der Prozeßschritte reduziert und dabei rasch und kostengünstig zu Produkten führt, die qualitativ hervorragend sind. Dabei gewährleistet das Verfahren hohe Sicherheit hinsichtlich einer reproduzierbaren Verfahrensweise. Die anschließende Metallisierung ist nicht nur wie üblich außenstromlos, sondern auch direkt galvanisch durchführbar. Dieses Verfahren kann durch folgende allgemeine Arbeitsgänge charakterisiert werden:
1. oxidative Vorbehandlung,
2. Spülen,
3. Katalyse,
4. Aktivierung,
5. Spülen,
6. vorzugsweise galvanische oder aber außenstromlose Metallisierung.

Die durchbohrte Leiterplatte wird nach diesem Verfahren vorbehandelt und außenstromlos oder bevorzugt direkt durch galvanische Metallabscheidung durchkontaktiert.

Die so hergestellten durchkontaktierten Leiterplatten können dann in bekannter Weise mit einem Sieb- oder Photodruck belegt werden, um nach dem Belichten und Entwickeln das Leiterbild zu erzeugen. Dann erfolgt der Leiterbildaufbau in Pattern Plating durch galvanische Abscheidung metallischer Schichten.

Dieses Verfahren hat jedoch den Nachteil, daß nach einem ersten Galvanisierungsschritt zur Durchkontaktierung der Bohrlochwandungen zunächst der Photoprozeß zum Aufbau des Leiterbildes zwischengeschaltet und erst dann in einem weiteren Galvanisierungsschritt das Leiterbild ebenfalls galvanisch oder außenstromlos verkupfert wird.

Die Erfindung hat sich daher die Aufgabe gestellt, ein vereinfachtes Verfahren zur Herstellung von durchkontaktierten ein- oder mehrlagigen Leiterplatten in Pattern Plating zur Verfügung zu stellen, das die zwei Galvanisierungsschritte zu einem Galvanisierungsschritt zusammenfaßt, wodurch das Verfahren vereinfacht und verbilligt wird.

Die der Erfindung zugrunde liegende Aufgabe wird gelöst durch ein Verfahren, das dadurch gekennzeichnet ist, daß
a) die Oberflächen des Trägers nach Bohren und anschließender mechanischer Oberflächenbehandlung mit einem geeigneten Photoresist laminiert, belichtet und entwickelt werden, so daß das Leiterbild freiliegt,
b) die Oberflächen des Trägers in einer oxidierend wirkenden Lösung vorbehandelt werden,
c) nach Entfernung der Lösungsreste durch Spülen der Träger in eine Lösung gebracht wird, welche ein heterocyclisches Monomeres, insbesondere Pyrrol, Thiophen, Furan oder deren Derivate, das in polymerer Form elektrisch leitend ist, enthält,
d) der Träger danach in eine saure Lösung gebracht wird, wobei sich eine elektrisch leitende polymere Schicht ausbildet, woraufhin gegebenenfalls Lösungsreste durch Spülen entfernt werden und anschließend Bohrlöcher und Schaltungsbild in einem Schritt bevorzugt galvanisch oder aber außenstromlos metallisiert werden.

In einer weiteren Ausführungsform wird die Reihenfolge der Schritte a) und b) vertauscht, wobei dem Schritt a) ein Spül- und Trocknungsschritt sowie eine mechanische Oberflächenreinigung vorgeschaltet sind.

Es ist weiterhin besonders vorteilhaft, dem Schritt b) Verfahrensgänge vorzuschalten, bei denen die gebohrte Leiterplatte einem Anätzvorgang und einer Oberflächenvorbehandlung der Leiterplatten unterworfen wird. Das Anätzen geschieht durch eine saure, oxidativ wirkende Lösung. Die Behandlung der Bohrlochwandungen, die nicht leitend sind, erfolgt mittels organischer, vorzugsweise stickstoffhaltiger Lösungsmittel oder deren wäßriger, alkalischer Lösungen, die gegebenenfalls Netzmittel enthalten.

Die Erfindung betrifft außerdem die Verwendung einer wäßrigen Lösung gemäß Anspruch 11 in einem Verfahren gemäß einem der vorangehenden Verfahrensansprüche.

Die Lösung, die für den Verfahrensschritt b) verwendet wird, enthält Salze des Permanganates, des Manganates, des Perjodates und/oder einer Cer-IV-Verbindung. Die im folgenden noch genauer zu beschreibende oxidative Vorbehandlung kann in einem pH-Bereich von < 1 bis 14 und bei Temperaturen von 20 bis 95°C durchgeführt werden. Der Zusatz von ionischen oder nichtionischen Tensiden in einer Menge von 0,1 bis 10 g/l verbessert die Qualität der oxidativen Vorbehandlung, ist jedoch nicht essentiell. Die oxidativ wirkenden Agentien liegen in einer Konzentration von 0,1 g/l bis zu ihrer Löslichkeitsgrenze vor. Die Vorbehandlungsdauer kann zwischen 0,2 und 20 min liegen.

Die Lösung, die für den Schritt c) verwendet wird, enthält vorzugsweise neben 1 bis 50% Pyrrol die komplementäre Menge an Lösungsmitteln bzw. Lösungsvermittlern sowie gegebenenfalls auch alkalisierende Zusätze. Selbstverständlich können auch Mischungen von Lösungsmittel bzw. Lösungsvermittler verwendet werden. Als Lösungsmittel bzw. Lösungsvermittler sind z.B. Wasser, Methanol, Ethanol, n-Propanol, Isopropanol, höhere Alkohole, Polyalkohole, DMF (Dimethylformamid), Ketone, insbesondere Methylethylketon, Cumolsulfonat, N-Methylpyrrolidon, Triglyme, Diglyme, Alkalisalze der Toluolsulfonate bzw. deren Ethylester sowie wäßrige gegebenenfalls alkalische Lösungen oder Gemische derselben verwendbar.

Im Anschluß an den Verfahrensschritt c) werden die zu metallisierenden Gegenstände wie Leiterplatten im Verfahrensschritt d) einer Aktivierung unterzogen. Die Aktivierung kann mit oxidativ wirkenden Substanzen wie zum Beispiel Alkalipersulfaten, Alkaliperoxodisulfaten, Wasserstoffperoxid, Eisen(III)-Salzen wie Eisenchlorid, Eisensulfat, Kaliumhexacyanoferat(III), Alkaliperjodaten oder ähnlichen Verbindungen im sauren Medium durchgeführt werden. Ebenso besteht die Möglichkeit, die Aktivierung nur in einem sauren Medium erfolgen zu lassen, wobei als Säuren Salzsäure, Schwefelsäure, Phosphorsäure etc. Verwendung finden können. Die Aktivierung kann sowohl im sauren, oxidierenden Medium als auch im sauren Medium gegebenenfalls mit permanenter Lufteinblasung erfolgen.

Die im Anschluß an die Verfahrensschritte a), b) und c) folgende galvanische Weiterverarbeitung der zu metallisierenden Gegenstände wie z.B. Leiterplatten wird in den folgenden Abschnitten noch näher erläutert.

In einer bevorzugten Ausführungsform des erfindungsgemäßen Verfahrens werden Metalle wie Kupfer, Nickel, Gold, Palladium, Zinn, Blei, Zinn/Blei zur Herstellung der Metallschicht verwendet.

Durch das erfindungsgemäße Verfahren wird eine durchkontaktierte ein- oder mehrlagige Leiterplatte auf Basis eines gegebenenfalls beidseitig mit mindestens einer das elektrisch leitende Leitungsbild temporär freilegenden Photoresistschicht versehenen polymeren Trägermaterials oder Keramik erhalten. Diese durchkontaktierte Leiterplatte ist dadurch gekennzeichnet, daß zwischen der Metallschicht auf der Innenfläche der durchkontaktierten Bohrlöcher und dem Trägermaterial oder der Keramik eine Schicht aus polymerisiertem, elektrisch leitenden Kunststoff ist. Die Schicht aus elektrisch leitendem Kunststoff besteht insbesondere aus polymerisiertem Pyrrol oder seinen Derivaten. Die Schicht aus polymerisiertem Kunststoff ist vorzugsweise 0,1 bis 10 µm dick.

Als Zwischenprodukt entsteht dabei eine durchbohrte ein- oder mehrlagige Platte auf Basis eines gegebenenfalls beidseitig mit mindestens einer das elektrisch leitende Leitungsbild freilegenden Photoresistschicht versehenen polymeren Trägermaterials oder Keramik, wobei auf der das Bohrloch umgrenzenden Fläche eine Schicht aus polymerisiertem, elektrisch leitenden Kunststoff angeordnet ist, die vorzugsweise aus polymerisiertem Pyrrol oder Pyrrolderivaten besteht.

Als Trägermaterialien kommen insbesondere glasfaserverstärktes Epoxidharz, Polyimid und andere feste Polymere in Frage. Prinzipiell sind alle Materialien geeignet, die mit einer Metallschicht überziehbar sind, indem sie nach den erfindungsgemäßen Verfahrensschritten behandelt werden. Die erfindungsgemäßen durchkontaktierten Leiterplatten sind nach dem erfindungsgemäßen Verfahren prinzipiell auf drei verschiedenen Wegen herstellbar.

Die Metallabscheidung kann zunächst unter Zuhilfenahme von polymeren, elektrisch leitenden, heterocyclischen Verbindungen wie Pyrrol, Thiophen und Furan unter Mitverwendung außenstromlos, reduktiv arbeitender Elektrolyte erfolgen.

Eine nach der Vorbehandlungsmethode, welche im folgenden noch beschrieben wird, vorbehandelte Leiterplatte aus einem Trägermaterial wie glasfaserverstärktem Epoxidharz wird in einen reduktiv arbeitenden Elektrolyten eingebracht, so daß auf chemischem Wege Metall, vorzugsweise Kupfer zur Abscheidung gebracht wird.

Eine andere Art der Metallabscheidung erfolgt unter Zuhilfenahme von polymeren, elektrisch leitenden, heterocyclischen Verbindungen, insbesondere Pyrrol, Thiophen und Furan, ohne Anwendung von außenstromlos, reduktiv arbeitenden Elektrolyten. Dabei wird vorzugsweise Kupfer zur Abscheidung gebracht. Eine nach der erfindungsgemäßen Vorbehandlungsmethode, welche im folgenden noch beschrieben wird, vorbehandelte Leiterplatte aus einem Trägermaterial wie glasfaserverstärktem Epoxidharz wird in einen galvanisch arbeitenden Kupferelektrolyten eingebracht, so daß eine Kupferabscheidung sowohl auf der vorbehandelten Kupferkaschierung der Leiterplatte als auch auf den vorbehandelten Bohrlochwandungen erfolgt.

Das Verfahren faßt die zwei Galvanisierungsschritte des Standes der Technik zusammen, indem die Trägermaterialien, die bereits mit einem entwickelten Photoresist versehen sind, zunächst der Katalyse und Aktivierung unterzogen und danach einer bevorzugt galvanischen oder aber außenstromlosen Verkupferung der Bohrlochwandungen und des durch den Photoresist freiliegenden Leiterbildes zugeführt werden.

Im folgenden werden die Verfahrensschritte des erfindungsgemäßen Verfahrens näher erläutert.

Das Verfahren kann durch folgende Arbeitsschritte charakterisiert werden:
a) Leiterplatten mit Photoresist laminieren, belichten, entwickeln,
b) oxidative Vorbehandlung,
c) Spülen,
d) Katalyse,
e) Aktivierung,
f) Spülen,
g) gegebenenfalls Dekapieren,
h) galvanische oder chemische Verkupferung.

In einer bevorzugten Ausgestaltung des Verfahrens kann dem Schritt b) der oxidativen Vorbehandlung ein Vorgang zum Anätzen, ein Spülvorgang, ein Reinigungsschritt und eine Reinigung und Oberflächenbehandlung der Bohrlöcher, gefolgt von einem weiteren Spülvorgang, vorgeschaltet werden.

In einer weiteren Ausführungsform kann die Reihenfolge der Schritte a) und b) vertauscht werden, wobei dem Schritt a) ein Spül- und Trocknungsschritt sowie eine mechanische Oberflächenreinigung vorgeschaltet sind.

Die kupferkaschierten, durchbohrten Leiterplatten werden zunächst mit einem geeigneten Photoresist laminiert, belichtet und entwickelt, so daß nach dem Verfahrensschritt a) das Leiterbild freiliegt. Das Anätzen der Leiterplatte wird in einer handelsüblichen sauren, mit oxidativ wirkenden Substanzen versehenen Lösung vorgenommen, so daß alle zugänglichen Kupferbereiche eine gleichmäßige feinstrukturierte Oberfläche erhalten.

Nach der Behandlung soll die Oberfläche frei von oxidischen Bereichen, von Fingerabdrücken und sonstigen Verunreinigungen sein und eine gleichmäßige helle Farbe aufweisen.

Der Prozeßschritt der Reinigung und Oberflächenvorbehandlung der nicht leitenden Bereiche der Leiterplatte (Bohrlochwandungen), welcher neben der Reinigung auch die Aktivierung und Konditionierung der nicht leitenden Bereiche einer Leiterplatte bewirkt, wird mit Hilfe eines organischen Lösungsmittels, vorzugsweise mit einem stickstoffhaltigen Lösungsmittel oder mit einer wäßrigen alkalischen Lösung der entsprechenden Lösungsmittel, die gegebenenfalls Netzmittel enthalten, durchgeführt. Neben der Aktivierung und Konditionierung führt dieser Prozeßschritt bei der Vorbehandlung von Mehrlagenschaltungen dazu, daß eventuell vorhandene Verunreinigungen der Kupferinnenlagen auf den Bohrlochwandungen für eine anschließende Entfernung der Verunreinigung vorbereitet werden. Die Behandlungsdauer sollte im allgemeinen zwischen 0,2 und 20 Minuten liegen und bei Temperaturen von 20 bis 80°C durchgeführt werden. Die vorgeschalteten Schritte bewirken eine optimale Vorbehandlung der Leiterplatten für den nachfolgenden Prozeß.

Zur Vorbereitung der Leiterplatten auf die galvanisch bzw. chemische Metallisierung müssen diese einer oxidativen Vorbehandlung, b), unterzogen werden. Die oxidative Vorbehandlung kann in einem pH-Bereich von < 1 bis 14 und bei Temperaturen von 20 bis 95°C durchgeführt werden. Der Zusatz von ionischen oder nichtionischen Tensiden in einer Menge von 0,1 bis 10 g/l verbessert die Qualität der oxidativen Vorbehandlung, ist jedoch nicht essentiell. Die oxidativ wirkenden Agentien liegen in einer Konzentration von 0,1 g/l bis zu ihrer Löslichkeitsgrenze vor. Die Vorbehandlungsdauer kann zwischen 0,2 und 20 Minuten liegen. Als Oxidationsmittel können zum Beispiel Cer(IV)Sulfat, Alkalimanganate, Alkalipermanganate und Alkaliperjodate zur Anwendung kommen. Vorzugsweise wird Kaliumpermanganat verwendet.

Als oxidatives Medium zur Vorbehandlung der zu metallisierenden Leiterplatten im alkalischen Medium wird z.B. eine wäßrige Lösung, bestehend aus 50 g/l Kaliumpermanganat und 50 g/l Natriumhydroxid, hergestellt. Es ist vorteilhaft, etwa 0,1 g/l nicht-ionogenes Fluortensid der Mischung zuzugeben. Die Leiterplatten werden vorzugsweise bis zu 10 Minuten unter leichter Bewegung in der temperierten Lösung belassen. Nach der Vorbehandlung werden die Leiterplatten mit Wasser abgespült.

Als oxidatives Medium zur Vorbehandlung der zu metallisierenden Leiterplatten im neutralen Medium wird eine wäßrige Lösung, bestehend aus 12 g/l Kaliumpermanganat, 0,1 g/l nicht-ionogenem Fluortensid unter Verwendung von pH-korrigierenden Substanzen (Natriumhydroxid, Schwefelsäure etc.). so eingestellt, daß die Lösung einen pH-Wert von ca. 7 aufweist. Die zu behandelnden Leiterplatten werden vorzugsweise 5 Minuten unter leichter Bewegung in der auf etwa 65°C temperierten Lösung belassen. Nach der oxidativen Vorbehandlung werden die Leiterplatten mit Wasser abgespült.

Als oxidierendes Medium zur Vorbehandlung der zu metallisierenden Leiterplatten im sauren Medium wird eine wäßrige Lösung, bestehend aus 10 g/l Kaliumpermanganat, 0,1 g/l nicht-ionogenem Netzmittel und Schwefelsäure hergestellt, die einen pH-Wert von ca. 2 aufweist. Die zu behandelnden Leiterplatten werden vorzugsweise etwa eine Minute unter leichter Bewegung in der Lösung belassen. Die Temperatur der Lösung beträgt vorzugsweise 20 bis 30°C. Im Anschluß an die oxidative Vorbehandlung werden die Leiterplatten mit Wasser abgespült.

Als oxidierendes Medium wird eine wäßrige Lösung von 50 g/l Cer(IV)Sulfat, nicht-ionogenem Netzmittel und Schwefelsäure so hergestellt, daß der pH-Wert < 1 ist. Die zu behandelnden Leiterplatten werden vorzugsweise ca. 5 Minuten unter leichten Schwenkbewegungen in der vorzugsweise auf 20 bis 30°C temperierten Lösung belassen. Im Anschluß an die oxidative Vorbehandlung werden die Leiterplatten mit Wasser abgespült.

Als ein weiteres oxidierendes Medium wird eine wäßrige Lösung von 50 g/l Natriumperjodat, einem nicht-ionogenen Netzmittel und Schwefelsäure so hergestellt, daß der pH-Wert der Lösung < 1 ist. Die zu behandelnden Leiterplatten werden 5 Minuten unter leichten Schwenkbewegungen in der temperierten Lösung belassen. Im Anschluß an die oxidative Vorbehandlung werden die Leiterplatten mit Wasser abgespült.

Für den Verfahrensschritt der Katalyse, c), wird eine Lösung, bestehend aus einer heterocyclischen Monomeren, insbesondere Pyrrol, Thiophen, Furan oder deren Derivate, einem mit Wasser mischbaren organischen Lösungsmittel wie Methanol, Ethanol, n-Propanol, Isopropanol, höhere Alkohole, Polyalkohole, DMF (Dimethylformamid), Ketone, Cumolsulfonat, N-Methylpyrrolidon, Triglyme, Diglyme, Alkalisalze der Toluolsulfonate bzw. deren Ethylester sowie wäßrigen alkalischen Lösungen oder Gemischen derselben als Lösungsvermittler für die heterocyclische Verbindung und Wasser eingesetzt. In diese Lösung werden die zu metallisierenden Substrate (Leiterplatten) eingebracht. Aufgrund der hohen Reaktivität der oxidativ vorbehandelten Leiterplatten kann die Konzentration der heterocyclenhaltigen Katalysierungslösung in weiten Bereichen gehalten werden, so daß Lösungen mit einem Heterocyclengehalt von 0,1 bis 50% eingesetzt werden können. Es hat sich jedoch herausgestellt, daß solche Lösungen, die einen Heterocyclenanteil von 5 bis 35% aufweisen, optimale katalysierende Eigenschaften aufweisen. Die Verweildauer der Leiterplatten in der Katalysatorlösung kann zwischen wenigen Sekunden und 20 Minuten betragen. Als optimal haben sich Verweilzeiten zwischen 0,2 und 5 Minuten herausgestellt. Während der Behandlung der Substrate wie Leiterplatten in der Katalysatorlösung können diese einer leichten Bewegung unterworfen werden.

Im Anschluß an die Katalyse werden die zu metallisierenden Leiterplatten einer Aktivierung, d), unterzogen als Vorbereitung auf die folgende Metallabscheidung. Die Aktivierung kann mit oxidativ wirkenden Substanzen wie zum Beispiel Alkalipersulfaten, Alkaliperoxodisulfaten, Wasserstoffperoxid, Eisen(III)-Salzen wie Eisenchlorid, Eisensulfat, Kaliumhexacyanoferat (III), Alkaliperjodaten oder ähnlichen Verbindungen im sauren Medium-durchgeführt werden. Ebenso besteht die Möglichkeit, die Aktivierung nur in einem sauren Medium erfolgen zu lassen, wobei als Säuren Salzsäure, Schwefelsäure, Phosphorsäure etc. Verwendung finden können. Die Aktivierung kann aber auch im sauren Medium unter permanenter Lufteinblasung erfolgen.

Zur Aktivierung der zu metallisierenden Leiterplatten im sauren, oxidierenden Medium wird das katalysierte Substrat 0,2 bis 5 Minuten in einer wäßrigen Lösung, bestehend aus 50 g/l Natriumperoxodisulfat und 10 ml/l Schwefelsäure unter leichten Schwenkbewegungen belassen. Es bildet sich auf der Oberfläche der Leiterplatte und auf den Bohrlochwandungen ein dunkelbraun bis schwarz gefärbter Film. Im Anschluß an die Aktivierung wird unter fließendem Wasser gespült.

Des weiteren kann die Aktivierung in einer wäßrigen Lösung aus 50 g/l Eisen(III)-Sulfat und 30 ml/l Schwefelsäure durchgeführt werden. In dieser Lösung wird ein katalysiertes Substrat unter leichten Schwenkbewegungen analog den oben genannten Zeiten belassen. Es bildet sich auf der gesamten Oberfläche ein dunkel gefärbter Überzug. Im Anschluß an die Aktivierung wird mit Wasser gespült.

Die Aktivierung der zu metallisierenden Leiterplatten erfolgt innerhalb von etwa 0,2 bis 5 Minuten im sauren Medium, bestehend aus einer etwa 20%-igen Schwefelsäurelösung, unter leichten Schwenkbewegungen und permanenter Lufteinblasung. Im Anschluß an die Aktivierung wird unter fließendem Wasser gespült.

Wird eine 5%-ige Salzsäurelösung zur Aktivierung verwendet, wird das entsprechend vorbehandelte Substrat vorzugsweise 0,2 bis 10 Minuten lang unter leichten Schwenkbewegungen in der Lösung belassen. Auch nach der erfolgten Aktivierung mit 5%-iger Salzsäure wird das Substrat mit Wasser gespült.

Bei Verwendung von 8%-iger Phosphorsäure wird das zu aktivierende Substrat 0,2 bis 10 Minuten lang unter leichten Schwenkbewegungen und permanenter Lufteinblasung in der entsprechenden Lösung belassen. Im Anschluß an die Aktivierung wird mit Wasser gespült.

Die Aktivierung kann ebenfalls durchgeführt werden, indem ein vorbehandeltes Substrat etwa 0,2 bis 10 Minuten lang in einer wäßrigen Lösung, bestehend aus 60 g/l Natriumperoxodisulfat und 40 ml/l H₂SO₄ unter leichten Schwenkbewegungen und permanenter Lufteinblasung belassen wird. Auch im Anschluß an diese Art der Aktivierung wird mit Wasser gespült.

In einer weiteren bevorzugten Ausgestaltung wird ein katalysiertes Substrat etwa 3 Minuten lang in einer Lösung, bestehend aus 100 ml Schwefelsäure und 25 ml Wasserstoffperoxid (30 %-ig) unter permanenter Lufteinblasung und leichter Schwenkbewegung belassen. Im Anschluß an die Aktivierung wird auch hier mit Wasser gewaschen.

Die oben genannten Mengenangaben, sowohl Gramm als auch Milliliter, beziehen sich jeweils auf 1 Liter Gesamtlösung.

Die nach dem oben beschriebenen Verfahren behandelten Leiterplatten können unmittelbar nach der Aktivierung einer außenstromlosen, reduktiven Metallabscheidung unterworfen werden. Vorzugsweise wird eine galvanische Metallabscheidung unmittelbar nach erfolgter Aktivierung durchgeführt.

Zur außenstromlosen Metallisierung werden handelsübliche Elektrolyte, vorzugsweise Kupferelektrolyte, wie z.B. METALYT^{(R)} CU NV, unter den üblichen Bedingungen, die jedem Fachmann bekannt sind, eingesetzt.

Die galvanische Metallabscheidung erfolgt mittels bekannter galvanischer Elektrolyte. Es können prinzipiell alle Metalle bzw. Legierungen abgeschieden werden, die auf galvanischem Wege abzuscheiden sind. Bevorzugt werden jedoch Kupferelektrolyte verwendet. Besonders bevorzugt sind schwefelsaure Kupferelektrolyte mit einem Gehalt von 50 bis 300 g/l freier Schwefelsäure und einem Metallgehalt von 5 bis 50 g/l. Aber auch fluorborsäure-, salzsäure-, thiosulfat- oder pyrophosphathaltige oder cyanidhaltige Elektrolyte sowie Elektrolyte auf Basis von Sulfaminen und organischen Sulfonsäuren haben sich als geeignet erwiesen. Diese Elektrolyte werden unter den üblichen Bedingungen, nämlich in Temperaturbereichen zwischen 20 und 70°C mit Stromdichten zwischen 0,1 und 20 A/dm² verwendet. Überraschenderweise kann die Zeit der galvanischen Abscheidung, wenn direkt im Anschluß an die erfindungsgemäße Aktivierung galvanisch verkupfert wird, erheblich verkürzt werden, nämlich in besonders günstigen Fällen auf 2 bis 5 Minuten. Man erhält gleichmäßige, geschlossene und darüber hinaus fest haftende Metallschichten, die auch im sogenannten Durchlichttest keinerlei Fehlstellen aufweisen.

Die folgenden Beispiele zeigen Teilaspekte der Erfindung:

### Beispiel 1:

Doppelseitig kupferkaschiertes Trägermaterial aus glasfaserverstärktem Epoxidharz wird in üblicher Weise gebohrt und mechanisch gereinigt. Anschließend wird das Substrat in einer wäßrigen Lösung, bestehend aus 50 g/l Kaliumpermanganat und 40 g/l Natriumhydroxid, bei 85°C 1 Minute behandelt. Danach wird gespült und getrocknet und leicht gebürstet. Nun wird ein handelsüblicher Fotoresist aufgebracht und so belichtet und entwickelt, daß das Leiterbild und die Bohrungen zur weiteren Metallisierung freiliegen.

Das so vorbereitete Substrat wird sodann in eine wäßrige Katalysatorlösung, bestehend aus 20 % Pyrrol und 20 % Isopropanol, getaucht und für etwa 1 Minute bei Raumtemperatur unter leichten Bewegungen in dieser Lösung belassen. Der nächste Behandlungsschritt erfolgt in einer Lösung von 10 ml/l H₂SO₄ und 10 g/l Natriumperoxodisulfat in Wasser. Auf der Oberfläche der nichtleitenden Zonen (Bohrung) bildet sich ein dunkelbrauner bis schwarzbrauner leitfähiger Polymerfilm, der anschließend unter fließendem Wasser gespült wird. Nun wird mit 5 % Schwefelsäure dekapiert und mit einem handelsüblichen sauren Kupferbad elektrolytisch verkupfert. Die Temperatur beträgt 23°C, die Stromdichte 2,3 A/dm². Nach etwa 60 Minuten waren Leiterbahnen und Bohrungen mit einer ca. 28 µm dicken Kupferschicht haftfest und vollständig überzogen.

### Beispiel 2

Ein doppelseitig kupferkaschiertes Trägermaterial aus glasfaserverstärktem Epoxidharz wird in üblicher Weise gebohrt und mechanisch gereinigt. Nun erfolgt direkt eine Belichtung mit einem handelsüblichen Fotoresist. Nach Belichten und Entwickeln liegen die zu metallisierenden Leiterbahnflächen und Bohrungen frei.

Anschließend wird das Substrat in einer wäßrigen Lösung von Wasserstoffperoxid und Schwefelsäure während 3 Minuten bei ca. 30°C angeätzt, gespült und in die oxidativ wirkende Vorbehandlung eingebracht. Die wäßrige Lösung enthält 12 g/l Kaliumpermanganat und 20 ml/l konz. Schwefelsäure. Das Trägermaterial wird unter leichter Bewegung 2 Minuten bei Raumtemperatur belassen. Danach wird gespült und in eine wäßrige Lösung von 10 g/l Zitronensäure getaucht. Im folgenden Schritt wird in eine wäßrige Katalysatorlösung, bestehend aus 10 % Pyrrol, 28 % Diethylenglykol und 0,1 ml/l Fluortensid getaucht (1 Minute/RT). Ohne zu spülen wird sodann in einer 50 % Schwefelsäure unter Lufteinblasung 1 Minute getaucht. In den Bohrungen bildet sich der leitfähige Polymerfilm aus. Nun wird gespült und mit 5 % Schwefelsäure dekapiert. Die Metallisierung erfolgt in einem handelsüblichen Kupferbad bei 23°C mit einer Stromdichte von 1,8 A/dm². Nach ca. 20 Minuten waren Leiterbild und Bohrungen mit einer ca. 25 µm starken Kupferschicht haftfest und vollständig überzogen.

### Beispiel 3

Wie zwei, aber ohne Zitronensäure
Katalysator: 4 % Pyrrol, 1 % Tiophen

### Beispiel 4

Wie zwei. Anstatt Permanganat-Oxidation:
Wäßrige Lösung: 50 g/l Cer(IV)sulfat und Schwefelsäure bei pH 1, 4 Minuten bei 25°C.

## Patentansprüche

1. Verfahren zur Herstellung von durchkontaktierten ein- oder mehrlagigen Leiterplatten auf Basis eines gegebenenfalls beidseitig mit mindestens einer das elektrisch leitende Leitungsbild temporär freilegenden Photoresistschicht versehenen polymeren Trägermaterials oder Keramik durch galvanisches oder außenstromloses Auftragen einer Metallschicht auf den Oberflächen, die nicht mit einer leitenden Metallschicht überzogen sind, wobei
a) die Oberflächen des Trägers nach Bohren und anschließender mechanischer Oberflächenbehandlung mit einem geeigneten Photoresist laminiert, belichtet und entwickelt werden, so daß das Leiterbild freiliegt,
b) die Oberflächen des Trägers in einer oxidierend wirkenden Lösung vorbehandelt werden,
c) nach Entfernung der Lösungsreste durch Spülen der Träger in eine Lösung gebracht wird, welche ein heterocyclisches Monomeres, insbesondere Pyrrol, Thiophen, Furan oder deren Derivate, das in polymerer Form elektrisch leitend ist, enthält,
d) der Träger danach in eine saure Lösung gebracht wird, wobei sich eine elektrisch leitende polymere Schicht ausbildet, woraufhin gegebenenfalls Lösungsreste durch Spülen entfernt werden und anschließend Bohrlöcher und Schaltungsbild in einem Schritt bevorzugt galvanisch oder aber außenstromlos metallisiert werden.

2. Verfahren nach Anspruch 1, dadurch gekennzeichnet, daß dem Schritt b) ein Anätzvorgang und ein Oberflächenvorbehandlungsschritt der Leiterplatten vorgeschaltet sind.

3. Verfahren nach Anspruch 1 und 2, dadurch gekennzeichnet, daß die Reihenfolge der Schritte a) und b) vertauscht wird, wobei dem Schritt a) ein Spül- und Trocknungsschritt sowie eine mechanische Oberflächenreinigung vorgeschaltet sind.

4. Verfahren nach einem der Ansprüche 1 bis 3, dadurch gekennzeichnet, daß das Anätzen der Leiterplatte in einer sauren, oxidativ wirkenden Lösung durchgeführt wird.

5. Verfahren nach einem der Ansprüche 1 bis 4, dadurch gekennzeichnet, daß zur Oberflächenvorbehandlung organische Lösungsmittel oder deren wäßrige alkalische Lösungen, die gegebenenfalls Netzmittel enthalten, eingesetzt werden.

6. Verfahren nach Anspruch 5, dadurch gekennzeichnet, daß die organischen Lösungsmittel Stickstoff enthalten.

7. Verfahren zur Herstellung von durchkontaktierten ein- oder mehrlagigen Leiterplatten gemäß einem der Ansprüche 1 bis 6, dadurch gekennzeichnet, daß die Metallschicht aus einem der Metalle Kupfer, Nickel, Gold, Palladium, Zinn, Blei, Zinn/Blei besteht.

8. Verfahren nach einem der Ansprüche 1 bis 7, dadurch gekennzeichnet, daß sich in der Lösung des Schrittes b) oxidierend wirkende Salze des Permanganats, des Manganats, des Perjodats und/oder Cer(IV)Sulfat befinden.

9. Verfahren nach einem der Ansprüche 1 bis 8, dadurch gekennzeichnet, daß der pH-Wert der oxidierend wirkenden Lösung zwischen < 1 und 14 liegt.

10. Verfahren nach einem der Ansprüche 1 bis 9, dadurch gekennzeichnet, daß die oxidierend wirkende Lösung ein Tensid enthält.

11. Verwendung einer wäßrigen Lösung, enthaltend 1 bis 50% Pyrrol sowie 99 bis 50% Lösungsmittel oder Lösungsvermittler oder 99 bis 50% eines Gemisches aus Lösungsmittel und Lösungsvermittler in einem Verfahren gemäß einem der Ansprüche 1 bis 10 zur Durchführung der Stufe c .

## Claims

1. A process for manufacturing through-hole plated single-layer or multi-layer printed circuit boards based on a polymeric substrate material or on a ceramic material provided optionally on both sides with at least one photo-resist layer temporarily exposing the electroconductive circuit pattern by electroplating or electroless plating with a metal layer on those surfaces which have not been coated with a conductive metal layer, wherein
a) the surfaces of the substrate, after hole-drilling and a subsequent mechanical surface-treatment, are laminated with a suitable photoresist, exposed to light and developed so that the circuit pattern image is exposed to the air,
b) the surfaces of the substrate are pre-treated in a solution having oxidizing activity,
c) after removal of the residual solution by rinsing, the substrate is introduced into a solution which contains at least one heterocyclic monomer, and more specifically pyrrole, thiophene, furane or derivative(s) thereof, which in a polymeric form is electrically conductive,
d) the substrate is then transferred into an acidic solution whereby an electrically conductive polymeric layer is formed,
whereupon, if desired or required, any residual solution is removed by rinsing, and the through-holes and the circuit pattern image are metallized in one step by galvanic or, preferably, electroless metallization.

2. The process according to claim 1, characterized in that the step b) is preceded by a procedure of initial etching and by a step of a surface pre-treatment of the printed circuit boards.

3. The process according to claims 1 and 2, characterized in that the sequence of steps a) and b) is reversed, with step a) being preceded by a step of rinsing and drying and a mechanical surface cleaning operation.

4. The process according to any one of claims 1 to 3, characterized in that the initial etching of the printed circuit board is effected by an acidic solution having oxidative activity.

5. The process according to any one of claims 1 to 4, characterized in that organic solvents or the aqueous alkaline solutions thereof which optionally contain wetting agents are employed for the surface pre-treatment.

6. The process according to claim 5, characterized in that the organic solvents contain nitrogen.

7. The process for manufacturing through-hole plated single-layer or multi-layer printed circuit boards according to any one of claims 1 to 6, characterized in that the metal layer consists of one of the metals copper, nickel, gold, palladium, tin, lead, tin/lead.

8. The process according to any one of claims 1 to 7, characterized in that the solution of step b) contains oxidizing permanganate, manganate, periodate salts and/or cerium(IV) sulfate.

9. The process according to any one of claims 1 to 8, characterized in that the pH value of the oxidizing solution is between < 1 and 14.

10. The process according to any one of claims 1 to 9, characterized in that the oxidizing solution contains a surfactant.

11. Use of an aqueous solution containing from 1 to 50% of pyrrole and from 99 to 50% of a solvent or solubilizer or from 99 to 50% of a mixture comprising a solvent and a solubilizer in a process according to any one of the claims 1 to 10 for carrying out step c).

## Revendications

1. Procédé pour fabriquer des plaquettes à circuits imprimés à une ou plusieurs couches, pourvues de contacts traversants, sur la base d'un matériau de support polymère ou d'une céramique, pourvu éventuellement sur ses deux faces d'au moins une couche de résine photosensible dégageant temporairement la configuration électriquement conductrice, par dépôt galvanique ou sans apport de courant extérieur d'une couche métallique sur les surfaces qui ne sont pas recouvertes par une couche métallique conductrice, selon lequel
a) après perçage et traitement de surface mécanique ultérieur, on dépose une résine photosensible appropriée sur les surfaces de support, on les expose et on les développe de manière à dégager la configuration de conducteurs,
b) on applique aux surfaces du support un traitement préalable dans une solution oxydante,
c) après élimination des restes de solution par lavage, on place le support dans une solution qui contient un monomère hétérocyclique, notamment du pyrrol, du thiophène, du furane ou leurs dérivés, qui est électriquement conducteur sous forme polymérique,
d) on place ensuite le support dans une solution acide, si bien qu'il se forme une couche polymérique électriquement conductrice, à la suite de quoi on élimine éventuellement des restes de solution par lavage et ensuite on métallise, de préférence galvaniquement ou bien sans application d'un courant extérieur, des trous et l'image de circuits lors d'une étape opératoire.

2. Procédé selon la revendication 3, caractérisé en ce qu'avant l'étape b) on exécute une attaque chimique et une étape de traitement préalable des surfaces des plaquettes à circuits imprimés.

3. Procédé selon la revendication 1 et 2, caractérisé en ce qu'on permute la séquence des étapes a) et b), l'étape de lavage et de séchage ainsi qu'un nettoyage mécanique de la surface étant exécutés avant l'étape a).

4. Procédé selon l'une des revendications 1 à 3, caractérisé en ce que l'attaque chimique de la plaquette à circuits imprimés est exécutée dans une solution acide ayant une action oxydante.

5. Procédé selon l'une des revendications 1 à 4, caractérisé en ce que pour le traitement préalable de surface, on utilise des solvants organiques ou leurs solution alcalines aqueuses, qui contiennent éventuellement des agents de réticulation.

6. Procédé selon la revendication 5, caractérisé en ce que les solvants organiques contiennent de l'azote.

7. Procédé pour fabriquer des plaquettes à circuits imprimés à une ou plusieurs couches, pourvues de contacts traversants, selon l'une des revendications 1 à 6, caractérisé en ce que la couche métallique est constituée par l'un des métaux : cuivre, nickel, or, palladium, étain, plomb, étain / plomb.

8. Procédé selon l'une des revendications 1 à 7, caractérisé en ce que des sels à action oxydante du permanganate, du manganate, du périodate et/ ou du sulfate de cerium (IV) sont présents dans la solution utilisée lors de l'étape b).

9. Procédé selon l'une des revendications 1 à 8, caractérisé en ce que la valeur du pH de la solution à action oxydante est située entre < 1 et 14.

10. Procédé selon l'une des revendications 1 à 9, caractérisé en ce que la solution à action oxydante contient un agent tensio-actif.

11. Utilisation d'une solution aqueuse, contenant 1 à 50% de pyrrol ainsi que 99 à 50% de solvant ou d'agent de solubilisation ou 99 à 50% d'un mélange d'un solvant et d'un agent de solubilisation dans un procédé selon l'une des revendications 1 à 10 pour la mise en oeuvre de l'étape c).
